# FASCICULE DE BREVET EUROPEEN

(11) **EP 2 366 246 B1**
(45) Date de publication et mention de la délivrance du brevet: **08.08.2012**
(21) Numéro de dépôt: 09756738.2
(22) Date de dépôt: 23.11.2009
(51) Int. Cl.: H04N 5/378, H04N 5/374

(54) **CIRCUIT INTÉGRÉ MATRICIEL ET NOTAMMENT CAPTEUR D'IMAGE DE GRANDE DIMENSION**
INTEGRIERTES SCHALTUNGSARRAY UND INSBESONDERE GROSS BEMESSENER BILDSENSOR
INTEGRATED CIRCUIT ARRAY, AND IN PARTICULAR A LARGE-SIZED IMAGE SENSOR

(30) Priorité: 12.12.2008 FR 0807004
(43) Date de publication de la demande: 21.09.2011
(73) Titulaire: E2V Semiconductors, 38120 Saint Egrève (FR)
(72) Inventeur: JULIEN, Florian, F-38500 Voiron (FR); MONTMAYEUR, Xavier, F-38120 Saint-Egrève (FR)
(74) Mandataire: Guérin, Michel
(86) Numéro de dépôt international: PCT/EP2009/065606
(87) Numéro de publication internationale: WO 2010/066559

(56) Documents cités:
- EP-A- 0 527 563
- EP-A- 0 967 795
- EP-A- 1 473 926
- EP-B- 0 763 302
- US-A1- 2006 243 885

## Description

L'invention concerne les circuits intégrés de grande dimension organisés selon une matrice de circuits élémentaires nécessitant pour leur fonctionnement un adressage individuel de chaque circuit élémentaire.

Les mémoires de grande capacité entrent dans cette définition, les circuits élémentaires étant les points mémoire individuels ; les capteurs d'image électroniques de grandes dimensions (plusieurs centimètres de côté) entrent également dans cette définition, les circuits élémentaires étant les pixels fournissant un signal représentant l'éclairement d'un point d'image élémentaire ; les afficheurs matriciels peuvent également être concernés. Dans la suite on décrira l'invention principalement à propos des capteurs d'image qui comportent une matrice de pixels organisée en lignes et colonnes.

Lorsque le nombre de lignes des capteurs d'image et leur taille augmente, il faut faire particulièrement attention à l'organisation de la matrice de pixels qui permet cette augmentation de nombre de lignes ou de taille.

Dans une configuration classique pour une matrice de taille modérée et de résolution modérée, l'organisation est très simple : la matrice comprend X lignes et Y colonnes et il y a un décodeur de ligne permettant de sélectionner une ligne parmi X et un décodeur de colonne permettant de sélectionner une colonne parmi Y.

Mais lorsque le nombre de lignes augmente, on peut être amené à changer l'organisation dans le but de lire plus rapidement tous les pixels de la matrice. Une solution consiste par exemple à lire la matrice à la fois à partir du haut et à partir du bas. Les documents EP-B-763302, EP-A-527563, US-A-2006/243885 et EP-A-967795 divulguent des capteurs d'image dans lesquels chaque colonne de pixels est subdivisée en blocs (ou sous-ensembles) et dans lesquels chaque colonne est reliée à plusieurs circuits de lecture.

D'autre part, lorsque la taille du capteur augmente, on est limité par les techniques de photolithographie qui ne permettent pas en pratique d'exposer en une fois toute la surface de la matrice et qui nécessitent plutôt une exposition par morceaux selon la technique dite "stitching" consistant, au cours d'une étape de photolithographie, à exposer successivement plusieurs parties contiguës du circuit intégré. Mais une exposition de la surface par "stitching" peut poser des problèmes pour la réalisation des circuits de décodage de ligne.

La présente invention part de ces deux problématiques pour y apporter une solution, mais il faut comprendre que la solution peut être mise en oeuvre pour répondre soit à la première problématique soit à la deuxième, soit aux deux à la fois. On partira de la problématique de la photolithographie par "stitching" pour expliquer l'invention.

Dans ce type de photolithographie, adapté à des puces de plusieurs centimètres carrés, on peut utiliser plusieurs masques différents pour exposer successivement, au cours d'une étape de photolithographie, plusieurs zones de la puce, chacune avec son motif propre, jusqu'à exposer toute la surface de la puce puis les puces adjacentes sur la même tranche ("wafer"). Mais on peut aussi, avantageusement, utiliser un seul masque pour exposer plusieurs zones de la puce lorsque ces zones sont rigoureusement identiques. Cela est bien adapté à la réalisation de la matrice de pixels. La matrice peut être considérée comme une juxtaposition de plusieurs blocs identiques comprenant chacun un certain nombre de lignes. Un masque est défini pour un seul bloc, et ce masque peut être déplacé sur la surface à exposer autant de fois qu'il y a de blocs.

Mais il y a une difficulté : si on inclut dans un bloc non seulement des lignes de pixels mais aussi les éléments de décodage qui permettent d'adresser ces lignes, les blocs ne peuvent pas être tous identiques. En effet, la partie de décodeur pour un bloc n'est pas rigoureusement identique à la partie de décodeur pour un autre bloc. Les différences sont très petites mais elles existent.

Il faudrait donc en principe exposer le décodeur de ligne séparément de la matrice, ce qui oblige à une étape de fabrication supplémentaire ; la matrice serait exposée par blocs successifs, alors que le décodeur de ligne utiliserait un masque spécifique différent. Ce masque spécifique devrait d'ailleurs être de grande taille car le décodeur de ligne occupe toute la hauteur de la matrice.

On peut aussi rendre artificiellement identiques les blocs de la matrice de pixels, en rendant plus complexe la constitution de chaque pixel : un pixel comprend en général un transistor de sélection de ligne commandé par un conducteur de ligne associé à une ligne de pixels déterminée, ce conducteur de ligne étant relié au décodeur de ligne ; si la matrice est organisée en blocs rigoureusement identiques, on peut alors prévoir que chaque pixel comprend un transistor supplémentaire de sélection de bloc, relié à un autre conducteur de ligne provenant du décodeur de ligne. Une ligne de pixels ne serait commandée en lecture que si les deux conducteurs de ligne sont activés. On peut alors avoir des blocs rigoureusement identiques, incluant des blocs de décodeur de ligne identiques. Mais alors le décodage est plus complexe et surtout chaque pixel est plus complexe.

L'invention propose une autre solution d'organisation dans laquelle la matrice peut être composée de plusieurs blocs de tous identiques, chaque bloc incluant à la fois des lignes de pixels et la portion de décodeur de ligne associée à ces lignes. Cette invention est également une solution au problème d'accélération de la lecture des pixels d'une matrice à grand nombre de lignes. Elle est généralement applicable à des circuits matriciels qui ne sont pas nécessairement des capteurs d'image, mais elle est particulièrement intéressante pour les capteurs d'image.

Selon l'invention, on propose un circuit intégré comportant un ensemble de circuits élémentaires tous identiques, agencés en X lignes et Y colonnes, chaque ligne de circuits élémentaires étant adressée par un conducteur de ligne relié à un décodeur de ligne, caractérisé en ce que chaque colonne de circuits élémentaires est subdivisée en P blocs (P supérieur à 2) de circuits élémentaires, et en ce qu'il est prévu pour chaque colonne P circuits de lecture élémentaires juxtaposés placés à une même extrémité de cette colonne et associés chacun à un bloc respectif, et P conducteurs de colonne associés chacun à un circuit de lecture élémentaire respectif et un bloc respectif, un conducteur de colonne étant relié au circuit de lecture élémentaire associé et à tous les circuits élémentaires du bloc associé mais pas aux circuits élémentaires des autres blocs.

Les blocs de lignes sont juxtaposés entre le haut et le bas de la matrice. Ils sont en principe tous identiques mais on peut aussi envisager que le bloc inférieur et/ou le bloc supérieur soient différents, en nombre de lignes.

On prévoit de préférence que chacun des P blocs comprend P tronçons de conducteur s'étendant entre le haut et le bas du bloc, la disposition géométrique des tronçons de conducteurs d'un bloc étant identique à celle des autres blocs, chaque conducteur de colonne comprenant P tronçons de conducteur qui sont mis bout-à bout et qui sont pris chacun dans un bloc respectif. Les tronçons de conducteur sont reliés aux circuits élémentaires qui appartiennent au bloc considéré (et donc à une colonne considérée).

Les P tronçons de conducteurs d'un bloc sont de préférence disposés sur deux niveaux de métallisation différents, P-1 tronçons étant réalisés sur l'un des niveaux et un dernier tronçon utilisant le deuxième niveau pour croiser les P-1 premiers.

Si on considère un bloc comprenant P tronçons de conducteur, on peut prévoir une disposition particulière de ces tronçons : les P tronçons conducteurs d'un bloc, juxtaposés et arrangés selon un rang de 1 à P, comportent chacun une extrémité inférieure et une extrémité supérieure disposées de façon que l'extrémité inférieure d'un tronçon d'un rang donné situé dans un premier bloc vienne en contact avec l'extrémité supérieure d'un tronçon d'un autre rang situé dans un deuxième bloc placé au-dessus du premier. Le raccordement se fait de préférence selon une permutation circulaire des rangs des tronçons, un tronçon d'un premier rang d'un premier bloc venant en contact avec un tronçon d'un deuxième rang de l'autre bloc, et ainsi de suite.

L'invention est applicable de manière particulièrement avantageuse à un capteur d'image matriciel, dans lequel les circuits élémentaires agencés en lignes et colonnes sont des pixels photosensibles, et notamment des pixels actifs comprenant des transistors.

Par conséquent, en résumé, on comprend qu'on décompose une colonne de circuits élémentaires (mais toutes les colonnes sont traitées de la même manière) en P blocs et on met autant de circuits de lecture élémentaires par colonne qu'il y a de blocs dans la hauteur de la matrice. Les circuits de lecture élémentaires dans une colonne peuvent être sélectionnés par un décodeur spécifique si on veut accéder à l'information d'un pixel unique situé au croisement d'une ligne (adressée par un décodeur de ligne) et d'une colonne ; si le capteur est fait par photorépétition de blocs identiques, ce décodeur spécifique ne fait pas partie du motif de blocs photorépétés, alors que le décodeur de ligne de la matrice fait partie du motif de blocs photorépétés et adresse donc simultanément P lignes lorsqu'il reçoit une adresse.

Cette architecture peut être utilisée indépendamment des questions de photorépétition de motifs. Elle a en effet un intérêt tout particulier pour permettre une lecture très rapide dans le cas de matrices de à grand nombre de lignes ; en effet, on peut prévoir alors que les P circuits de lecture élémentaires placés en pied de colonne fournissent des signaux de sortie simultanément, c'est-à-dire qu'on peut lire P informations simultanées, issus de P lignes différentes adressées simultanément par le décodeur de ligne ; dans une organisation matricielle standard, on lirait une seule information, issue d'une seule ligne. Dans la configuration selon l'invention où on extrait de la matrice P signaux à la fois, il n'y a pas de décodeur spécifique (ou bien on ne l'utilise pas) pour sélectionner un circuit de lecture élémentaire parmi P, mais on sort les signaux de toute la matrice P fois plus vite que s'il n'y avait qu'un seul circuit élémentaire de lecture par colonne.

D'autres caractéristiques et avantages de l'invention apparaîtront à la lecture de la description détaillée qui suit et qui est faite en référence aux dessins annexés dans lesquels :
- la figure 1 représente l'architecture générale d'une matrice selon l'invention ;
- la figure 2 représente une organisation de conducteurs de colonnes adaptée à l'architecture selon l'invention ;
- la figure 3 représente l'organisation pratique du raccordement des tronçons de conducteurs de colonne faisant partie de deux blocs adjacents.

L'invention sera décrite à propos d'un exemple particulièrement intéressant qui est un capteur d'image matriciel de grande dimension (plusieurs centimètres de côté) comportant plusieurs centaines de lignes et plusieurs centaines de colonnes de pixels.

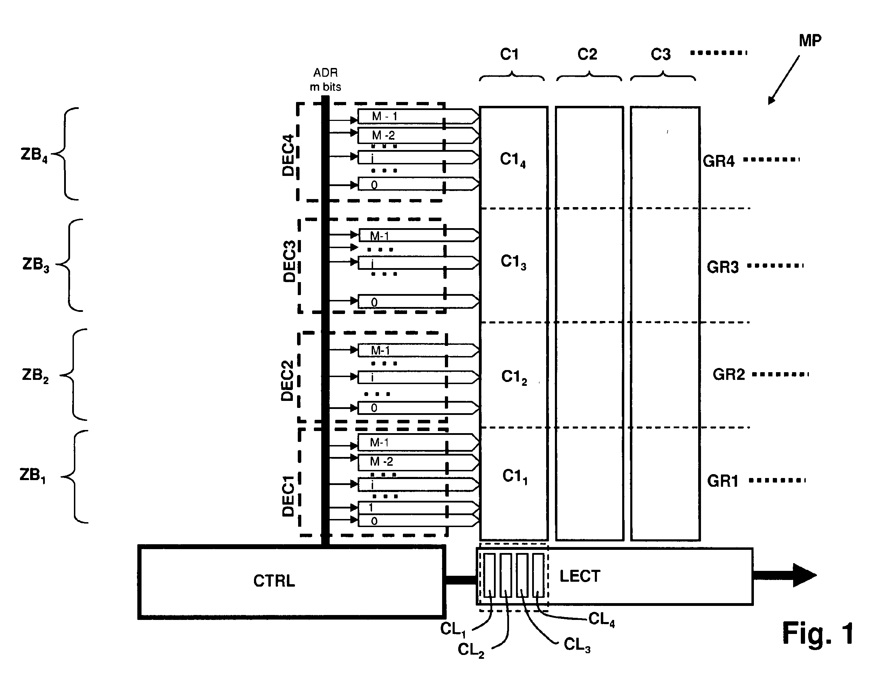

La figure 1 représente le principe de l'invention. La matrice de pixels est désignée par MP. Les lignes de pixels sont régulièrement réparties entre le haut et le bas de la matrice mais on considère que la matrice est divisée en plusieurs groupes de lignes ; les groupes sont désignés respectivement par GR1, GR2, GR3, GR4. Il y a X lignes au total et on peut considérer qu'il y a P groupes de M lignes (P supérieur ou égal à 2). La matrice est également constituée en Y colonnes de pixels et on a représenté des colonnes adjacentes C1, C2, C3, etc.

Du fait que la matrice est divisée en P groupes de lignes, chaque colonne de pixels est divisée en P blocs de pixels. Les blocs de pixels respectifs d'une même colonne sont désignés par les références C1₁, C1₂, C1₃, C1₄ pour la première colonne.

La matrice est destinée à être réalisée par photorépétition de plusieurs motifs ; dans l'exemple de la figure 1, on suppose que la puce comprend des zones successives ZB₁, ZB₂, ZB₃ et ZB₄ rigoureusement identiques et réalisées à chaque étape de photolithographie avec un même motif. Les groupes de lignes GR1 à GR4 font partie respectivement des zones ZB₁, ZB₂, ZB₃, et ZB₄. Les éléments de décodeur de ligne permettant de sélectionner les lignes sont eux-mêmes répartis en groupes DEC1 à DEC4 correspondant respectivement aux groupes de lignes-et ces groupes font partie des zones ZB₁, ZB₂, ZB₃, et ZB₄ respectivement. Les groupes DEC1 à DEC4 d'éléments de décodeur de ligne sont tous rigoureusement identiques. La sélection d'une adresse codée sur m bits sélectionne une ligne parmi M (ligne de rang 0 à M-1) dans chacun des groupes de lignes ; elle sélectionne donc P lignes à la fois.

Le nombre P de zones répétées à l'identique peut typiquement être compris entre 2 et 10. Il est de préférence très inférieur au nombre M des lignes de pixels présentes dans chaque zone ZB₁ à ZB₄. Dans ce qui suit on prend à titre d'exemple P=4. Le nombre M peut typiquement être égal à une ou plusieurs centaines.

On a représenté au bas de la matrice une circuiterie LECT de lecture des signaux issus de la matrice. On a représenté également sous forme d'un rectangle avec la référence CTRL tous les circuits de contrôle servant à faire fonctionner le capteur d'image. Ces circuits fournissent divers signaux et notamment tous les signaux nécessaires à l'adressage des lignes de la matrice (une adresse émise à destination des décodeurs de ligne, cette adresse étant codée sur m bits pour désigner une ligne parmi M) et éventuellement les signaux nécessaires à l'adressage des colonnes (une adresse codée sur y bits pour désigner une colonne parmi Y).

Habituellement, le décodeur de ligne permet de sélectionner une ligne unique parmi X, et on trouve au pied de la matrice un circuit de lecture élémentaire par colonne de pixels et un conducteur de colonne qui relie tous les pixels d'une même colonne à ce circuit de lecture élémentaire. Seul le pixel correspondant à la ligne sélectionnée fournit un signal sur le conducteur de colonne à destination du circuit de lecture élémentaire associé à la colonne.

Selon l'invention, on prévoit au pied de chaque colonne de pixels P circuits de lecture élémentaires CL₁, CL₂, CL₃, CL₄ associés à cette colonne. Plus précisément, chacun des P blocs de pixels d'une même colonne est relié à un circuit de lecture élémentaire respectif. Un conducteur de colonne respectif, non représenté sur la figure 1 pour ne pas alourdir le schéma, est associé à un bloc respectif de pixels et est relié à tous les pixels de ce bloc et au circuit de lecture correspondant mais pas aux pixels des autres blocs de la colonne ni aux circuits de lecture élémentaires correspondant aux autres blocs.

Le circuit de contrôle général CTRL peut comprendre des moyens pour sélectionner un bloc parmi P et cette sélection consiste dans la sélection d'un circuit de lecture élémentaire parmi P, ceci dans le cas où on veut extraire de la matrice l'information correspondant à un pixel déterminé au croisement d'une ligne et d'une colonne ; dans ce cas, le circuit de contrôle CTRL fournit à tous les éléments de décodeurs de ligne une adresse parmi M (adresse sur m bits), et il sélectionne en même temps un seul circuit de lecture élémentaire parmi P dans la colonne sélectionnée ; les P-1 circuits de lecture non sélectionnés dans la colonne sélectionnée restent inactifs.

Cette architecture de décodage permet de constituer une structure dans laquelle les groupes de lignes GR1, GR2, GR3, GR4 sont rigoureusement identiques les uns aux autres, y compris dans la partie décodeur DEC1, DEC2, DEC 3, DEC4. Ces groupes peuvent donc être réalisés par des étapes de photolithographie partielle par raboutage, avec le déplacement pas à pas d'un même masque.

Mais même si la structure matricielle de X lignes et Y colonnes n'est pas réalisée par des étapes de photolithographie par "stitching", l'invention procure un autre résultat, à savoir la possibilité d'obtenir une lecture plus rapide du contenu de la matrice si on sort en parallèle du circuit de lecture les P informations correspondant aux P pixels sélectionnés simultanément par le décodeur de ligne. Dans ce cas il n'est pas nécessaire que les circuits de contrôle CTRL comprennent des moyens pour sélectionner un circuit de lecture élémentaire parmi P.

Selon une caractéristique secondaire de l'invention, on propose que la disposition géométrique des conducteurs de colonne d'un bloc soit exactement identique à la disposition géométrique des conducteurs des autres blocs.

On s'est aperçu en effet que la subdivision des colonnes en P blocs de pixels raccordés à P conducteurs de colonne différents risquait de créer un bruit d'image fixe résultant de l'existence de structures de pixels variables dans la matrice selon la position du pixel dans la colonne, et plus précisément selon l'appartenance du pixel à tel ou tel des P blocs de pixels.

Dans la disposition de la figure 1, on pourrait imaginer que le conducteur de colonne (pour la colonne C1) qui relie les pixels du bloc C1₁ au circuit de lecture élémentaire CL₁ s'étend seulement sur la hauteur du bloc C1₁ et est donc beaucoup plus court que le conducteur de colonne qui relie les pixels du bloc C1₄ au circuit de lecture CL₄. Mais selon l'invention, on préfère que le premier conducteur mentionné s'étende jusqu'aux pixels du bloc C1₄ même s'il ne leur est pas raccordé, pour présenter la même longueur et la même capacité parasite que le conducteur raccordé aux pixels du bloc C1₄. Et la configuration géométrique de ces deux conducteurs de colonne est de préférence identique à la configuration géométrique de tous les conducteurs de colonne de la matrice.

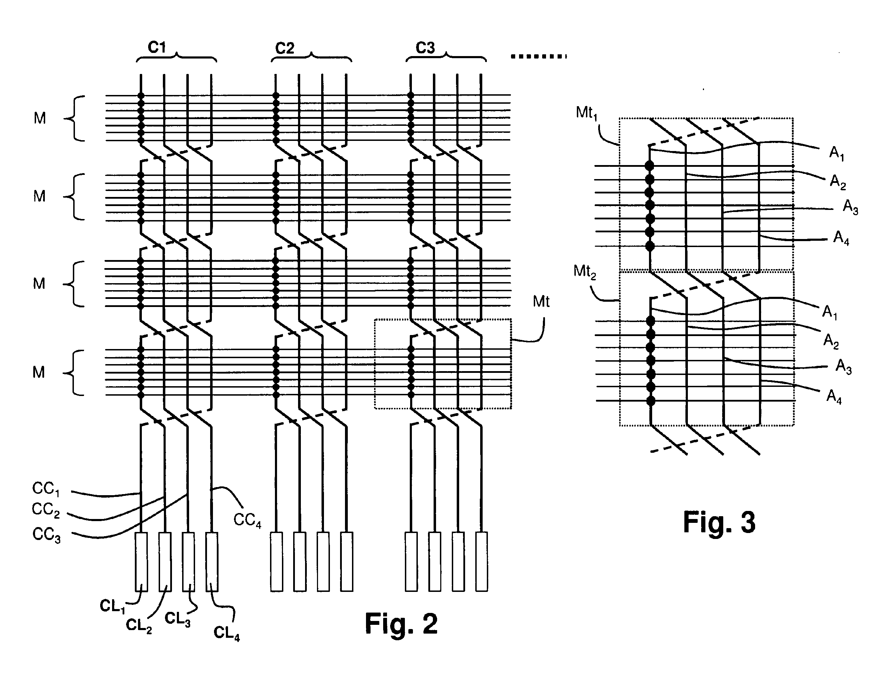

De préférence, on prévoit que les P conducteurs de colonne sont disposés sur deux niveaux de métallisation différents, P-1 conducteurs s'étendant parallèlement les uns aux autres sur l'un des niveaux et un dernier conducteur croisant les P-1 premiers sur le deuxième niveau. Et on prévoit de préférence aussi que les P circuits de lecture élémentaires sont disposés côte à côte au pied d'une colonne de pixels (comme cela est représenté à la figure 1 et à la figure 2).

La figure 2 représente une disposition possible des conducteurs de colonne pour optimiser la régularité de la disposition des pixels dans toute la matrice, en vue de réduire le plus possible le bruit de motif fixe.

Pour ne pas alourdir le schéma, on n'a pas représenté les pixels individuels situés au carrefour d'un conducteur de ligne et d'un conducteur de colonne. On a représenté seulement des points symboliques à chaque carrefour. Chaque point à l'intersection d'une ligne et d'une colonne représente le pixel qui est relié au conducteur de ligne respectif (pour être sélectionné par ce conducteur) et qui est par ailleurs relié au conducteur de colonne (pour fournir sur ce conducteur un signal représentant l'éclairement). Cette représentation symbolique ne signifie pas que le conducteur de ligne est relié au conducteur de colonne. Elle signifie seulement que le pixel est relié à ces deux conducteurs.

La représentation symbolique de la figure 2 ne prend pas en compte la régularité de répartition des pixels en ligne et en colonne. En effet, pour rendre le schéma plus lisible, on a nettement séparé les uns des autres chacun des P blocs de M pixels dans une colonne ; on a également nettement séparé les colonnes les unes des autres. Dans la réalité, l'espacement entre deux pixels d'une même colonne est à peu près égal à l'espacement entre deux pixels d'une même ligne, et ceci aussi bien lorsque les deux pixels en colonne appartiennent au même bloc de M et lorsqu'ils appartiennent à deux blocs différents. Enfin, les conducteurs de colonne sont représentés avec un espacement latéral exagéré entre eux pour faciliter la lisibilité.

Sur la figure 2, on a représenté une subdivision des pixels des colonnes en P=4 blocs juxtaposés. Les pixels de chaque bloc sont reliés à un conducteur de colonne respectif CC₁ à CC₄ lui-même relié respectivement à un circuit de lecture élémentaire associé CL₁ à CL₄.

Chacun des P conducteurs de colonne est réalisé par l'aboutement de P tronçons de conducteur appartenant chacun à un bloc respectif. Et chaque bloc comprend à cet effet P tronçons de conducteur destinés à réaliser les conducteurs de colonne.

Un motif élémentaire de dessin de tronçons de conducteurs est répété à l'identique pour chacun des P blocs de pixels d'une colonne, et d'ailleurs aussi à l'identique pour les autres colonnes. Ce motif est représenté sur la figure 2 dans un cadre pointillé désigné par la référence Mt. Ce motif est répété sur les P blocs pour assurer la symétrie de réalisation des P blocs, alors que du point de vue fonctionnel il ne serait pas nécessaire de prolonger tous les conducteurs de colonne jusqu'en haut de la matrice puisque seul l'un d'eux est connecté aux pixels du haut de la matrice.

Une manière préférée de réaliser ce motif répété de conducteurs de colonne est de prévoir qu'à l'intérieur d'un motif répété les P conducteurs sont réalisés dans un premier niveau de métallisation, à l'exception d'un des P conducteurs, lequel comporte au moins une partie réalisée dans un deuxième niveau de métallisation pour pouvoir croiser les autres. Sur la figure 2, cette partie est représentée en traits tiretés alors que les autres conducteurs sont représentés en traits pleins.

Dans la configuration préférée, représentée à la figure 2, le motif répété des P conducteurs servant à réaliser les conducteurs de colonne CC₁ à CC₄ est tel que le raccordement des P conducteurs d'un motif avec les P conducteurs d'un motif adjacent réalise une connexion selon une permutation circulaire. Cette connexion par permutation circulaire est expliquée en référence à la figure 3 : si on appelle A₁, A₂, A₃, A₄, les P conducteurs, de rang 1 à 4, d'un motif, tous identiques d'un motif à l'autre, les tracés de ces conducteurs sont tels que : l'extrémité inférieure du conducteur A₁ (rang 1) d'un motif Mt₁ placé au-dessus d'un motif adjacent Mt₂ vienne en contact avec l'extrémité supérieure du conducteur A₂ (rang 2) du motif Mt₂ ; l'extrémité inférieure du conducteur A₂ du motif supérieur Mt₁ vienne contacter l'extrémité supérieure du conducteur A₃ (rang 3) du motif Mt₂ ; et ainsi de suite par permutation circulaire, jusqu'à l'extrémité inférieure du conducteur A₄ (rang 4) du motif Mt₁ qui vient contacter l'extrémité supérieure du conducteur A₁ (rang 1) du motif Mt₂.

Dans cet exemple, c'est le conducteur A₁ de chaque motif qui comporte une partie en traits tiretés croisant tous les autres conducteurs et réalisée à cet effet sur un niveau métallique différent des autres.

## Revendications

1. Circuit intégré comportant un ensemble de circuits élémentaires tous identiques, agencés en X lignes et Y colonnes, chaque ligne de circuits élémentaires étant adressée par un conducteur de ligne relié à un décodeur de ligne, **caractérisé en ce que** chaque colonne de circuits élémentaires est subdivisée en P blocs (C1₁ à C1₄), P supérieur à 2, de circuits élémentaires, et **en ce qu'**il est prévu, pour chaque colonne, P circuits de lecture élémentaires (CL₁ à CL₄) juxtaposés, placés à une même extrémité de cette colonne et associés chacun à un bloc respectif, et P conducteurs de colonne (CC₁ à CC₄) associés chacun à un circuit de lecture élémentaire respectif et un bloc respectif, un conducteur de colonne étant relié au circuit de lecture élémentaire associé et à tous les circuits élémentaires du bloc associé mais pas aux circuits élémentaires des autres blocs.

2. Circuit intégré selon la revendication 1, **caractérisé en ce que** les blocs de lignes sont juxtaposés entre le haut et le bas de la matrice.

3. Circuit intégré selon l'une des revendications 1 et 2, **caractérisé en ce que** les circuits de lecture élémentaires associés à une colonne sont placés côte à côte en ligne.

4. Circuit intégré selon l'une des revendications 1 à 3, **caractérisé en ce que** chacun des P blocs comprend P tronçons de conducteur s'étendant entre le haut et le bas du bloc, la disposition géométrique des tronçons de conducteurs d'un bloc étant identique à celle des autres blocs, chaque conducteur de colonne comprenant P tronçons de conducteur qui sont mis bout-à bout et qui sont pris chacun dans un bloc respectif.

5. Circuit intégré selon l'une des revendications 1 à 4, **caractérisé en ce que** les P tronçons de conducteurs d'un bloc sont disposés sur deux niveaux de métallisation différents, P-1 tronçons étant réalisés sur l'un des niveaux et un dernier tronçon utilisant le deuxième niveau pour croiser les P-1 premiers.

6. Circuit intégré selon l'une des revendications 1 à 5, **caractérisé en ce que** les P tronçons conducteurs d'un bloc (A₁ à A₄), juxtaposés et arrangés selon un rang de 1 à P, comportent chacun une extrémité inférieure et une extrémité supérieure disposées de façon que l'extrémité inférieure d'un tronçon d'un rang donné situé dans un premier bloc (Mt₁) vienne en contact avec l'extrémité supérieure d'un tronçon d'un autre rang situé dans un deuxième bloc (Mt₂) placé au-dessus du premier.

7. Circuit intégré selon la revendication 6, **caractérisé en ce que** le raccordement entre les tronçons conducteurs de deux blocs adjacents est fait selon une permutation circulaire des rangs des tronçons, un tronçon d'un premier rang d'un premier bloc venant en contact avec un tronçon d'un deuxième rang de l'autre bloc, et ainsi de suite.

8. Circuit intégré selon l'une des revendications 1 à 7, **caractérisé en ce que** les circuits élémentaires de la matrice sont des pixels photosensibles, le circuit intégré étant un capteur d'image matriciel.

## Claims

1. An integrated circuit comprising a set of basic circuits, all identical, arranged in X rows and Y columns, each row of basic circuits being addressed by a row conductor linked to a row decoder, **characterized in that** each column of basic circuits is subdivided into P blocks (C1₁ to C1₄), P being greater than 2, of basic circuits, and **in that** there are provided, for each column, P juxtaposed basic read circuits (CL₁ to CL₄), placed at one and the same end of this column and each associated with a respective block, and P column conductors (CC₁ to CC₄) each associated with a respective basic read circuit and a respective block, a column conductor being linked to the associated basic read circuit and to all the basic circuits of the associated block but not to the basic circuits of the other blocks.

2. The integrated circuit as claimed in claim 1, **characterized in that** the blocks of rows are juxtaposed between the top and the bottom of the matrix.

3. The integrated circuit as claimed in one of claims 1 and 2, **characterized in that** the basic read circuits associated with a column are placed side by side in line.

4. The integrated circuit as claimed in one of claims 1 to 3, **characterized in that** each of the P blocks comprises P conductor sections extending between the top and the bottom of the block, the geometrical arrangement of the conductor sections of a block being identical to that of the other blocks, each column conductor comprising P conductor sections which are placed end-to-end and which are each taken in a respective block.

5. The integrated circuit as claimed in one of claims 1 to 4, **characterized in that** the P conductor sections of a block are arranged on two different metallization levels, P-1 sections being produced on one of the levels and a last section using the second level to intersect the P-1 first sections.

6. The integrated circuit as claimed in one of claims 1 to 5, **characterized in that** the P conductor sections of a block (A₁ to A₄), juxtaposed and arranged in a rank from 1 to P, each comprise a bottom end and a top end positioned so that the bottom end of a section of a given rank situated in a first block (Mt₁) comes into contact with the top end of a section of another rank situated in a second block (Mt₂) placed above the first.

7. The integrated circuit as claimed in claim 6, **characterized in that** the connection between the conductor sections of two adjacent blocks is made according to a circular permutation of the ranks of the sections, a section of a first rank of a first block coming into contact with a section of a second rank of the other block, and so on.

8. The integrated circuit as claimed in one of claims 1 to 7, **characterized in that** the basic circuits of the matrix are photosensitive pixels, the integrated circuit being a matrix image sensor.

## Patentansprüche

1. Integrierte Schaltung, die einen Satz von identischen Elementarschaltungen umfasst, die in X Reihen und Y Spalten angeordnet sind, wobei jede Reihe von Elementarschaltungen von einem Reihenleiter der mit einem Reihendecoder verbunden ist, adressiert wird, **dadurch gekennzeichnet, dass** jede Spalte von Elementarschaltungen in P Blöcke (C1₁ bis C1₄), wobei P größer als 2 ist, von Elementarschaltungen unterteilt ist, und dadurch, dass für jede Spalte P nebeneinander liegende Elementarleseschaltungen (CL₁ bis CL₄), die an einem selben Ende dieser Spalte platziert und jeweils mit einem jeweiligen Block assoziiert sind, und P Spaltenleiter (CC₁ bis CC₄) vorgesehen sind, die jeweils mit einer jeweiligen Elementarleseschaltung und einem jeweiligen Block assoziiert sind, wobei ein Spaltenleiter mit der assoziierten Elementarleseschaltung und mit allen Elementarschaltungen des assoziierten Blocks, aber nicht mit den Elementarschaltungen der anderen Blöcke assoziiert ist.

2. Integrierte Schaltung nach Anspruch 1, **dadurch gekennzeichnet, dass** die Reihenblöcke zwischen dem oberen und dem unteren Ende der Matrix nebeneinander liegen.

3. Integrierte Schaltung nach einem der Ansprüche 1 und 2, **dadurch gekennzeichnet, dass** die mit einer Spalte assoziierten Elementarleseschaltungen Seite an Seite in Reihe platziert sind.

4. Integrierte Schaltung nach einem der Ansprüche 1 bis 3, **dadurch gekennzeichnet, dass** jeder der P Blöcke P Leiterabschnitte umfasst, die zwischen dem oberen und dem unteren Ende des Blocks verlaufen, wobei die geometrische Anordnung der Leiterabschnitte von einem Block mit der der anderen Blöcke identisch ist, wobei jeder Spaltenleiter P Leiterabschnitte umfasst, die Ende an Ende liegen und die jeweils aus einem jeweiligen Block genommen werden.

5. Integrierte Schaltung nach einem der Ansprüche 1 bis 4, **dadurch gekennzeichnet, dass** die P Leiterabschnitte von einem Block auf zwei unterschiedlichen Metallisierungsniveaus angeordnet sind, wobei P-1 Abschnitte auf einem der Niveaus realisiert sind und ein letzter Abschnitt das zweite Niveau zum Überkreuzen der P-1 ersteren benutzt.

6. Integrierte Schaltung nach einem der Ansprüche 1 bis 5, **dadurch gekennzeichnet, dass** die P Leiterabschnitte von einem Block (A₁ bis A₄), die nebeneinander liegen und gemäß einem Rang von 1 bis P angeordnet sind, jeweils ein unteres Ende und ein oberes Ende umfassen, die so angeordnet sind, dass das untere Ende eines Abschnitts eines gegebenen Rangs, der sich in einem ersten Block (Mt₁) befindet, mit dem oberen Ende eines Abschnitts eines anderen Rangs in Kontakt kommt, der sich in einem zweiten Block (Mt₂) befindet, über dem ersten platziert.

7. Integrierte Schaltung nach Anspruch 6, **dadurch gekennzeichnet, dass** der Anschluss zwischen den Leiterabschnitten von zwei benachbarten Blöcken gemäß einer zyklischen Permutation der Ränge der Abschnitte erfolgt, wobei ein Abschnitt eines ersten Rangs eines ersten Blocks mit einem Abschnitt eines zweiten Rangs des anderen Blocks in Kontakt kommt usw.

8. Integrierte Schaltung nach einem der Ansprüche 1 bis 7, **dadurch gekennzeichnet, dass** die Elementarschaltungen der Matrix fotoempfindliche Pixel sind, wobei die integrierte Schaltung ein Matrix-Bildsensor ist.
